# EUROPEAN PATENT APPLICATION

(11) **EP 0 658 926 A1**
(43) Date of publication of application: **21.06.1995**
(21) Application number: 94117692.7
(22) Date of filing: 09.11.1994
(51) Int. Cl.: H01L 21/285, C23C 14/34, C23C 14/00

(54) **Method of producing a semiconductor device comprising a contact layer between the silicon substrate and a wiring layer**

(30) Priority: 22.11.1993 JP 291755/93
(71) Applicant: MATSUSHITA ELECTRIC INDUSTRIAL CO., LTD., Kadoma-shi, Osaka-fu, 571 (JP)
(72) Inventor: Yoshida, Takehito, Machida-shi, Tokyo 194 (JP); Hirao, Shuji, Hirakata-shi, Osaka 573 (JP); Yano, Kousaku, Katano-shi, Osaka 576 (JP)
(74) Representative: Grünecker, Kinkeldey, Stockmair & Schwanhäusser Anwaltssozietät

(57) **Abstract**

Argon gas is supplied into a vacuum chamber (3) having a target of titanium (2) for depositing a titanium layer (5) on a silicon substrate (3), and argon gas mixingly containing nitrogen is then supplied into the vacuum chamber (1) for depositing a titanium nitride layer (6) on the titanium layer (5). Thereafter, argon gas is again supplied into the vacuum chamber for removing nitrogen stuck to the surface of the target (2) and also for depositing a titanium-nitrogen mixture layer (9) on the titanium nitride layer (6).

## Description

### [Background of the Invention]

The present invention relates to a method of producing a semiconductor device having, on its semiconductor substrate of silicon, a highly integrated metallic wiring layer low in parasitic resistance.

With the demand for high integration of a semiconductor integrated circuit, the following is encountered in the active high-concentration diffusion layer formed on a silicon substrate (for example, the source/drain area in a MOS transistor or the emitter/base area in a bipolar transistor). That is, the depth of the p-n junction portion is shallower and the contact interface portion (contact portion) between the high-concentration diffusion layer and the metallic wiring layer, is reduced in area. In such a semiconductor device, in order to maintain, as ohmic and low, the electric resistance (contact resistance) at the interface between the active high-concentration diffusion layer and the metallic wiring layer and also in order to prevent the metal forming the metallic wiring layer from diffusing into the silicon substrate, it is inevitably required to dispose, between the high-concentration diffusion layer and the metallic wiring layer on the silicon substrate, a barrier layer formed by high-melting-point metal or a compound thereof. Such a barrier layer is also required when forming a contact portion between a silicon substrate and a resistor or electrode made of polycrystal silicon.

When an aluminium alloy (Al-Si-Cu) is used as the material of the metallic wiring layer, a titanium nitride (TiN) layer may be used as the barrier layer. Dependent on the forming method, such a titanium nitride layer has very effective barrier properties capable of restraining the diffusion, into the silicon substrate, of copper and aluminium in the metallic wiring layer when a heat treatment is conducted at 500°C. This is reported in, for example, "Journal of Vacuum Science and Technology" 21 (1982), PP 14-18.

In a barrier layer formed by a titanium nitride layer, however, the contact resistance becomes high particularly on a p-type high-concentration diffusion layer. To lower the contact resistance, it is required to dispose a titanium (Ti) layer between the titanium nitride layer and the high-concentration diffusion layer on the silicon substrate. This is because the titanium layer has the property of reducing the natural oxide layer on the silicon substrate and because the titanium layer is lower in the height of a Schottky barrier to a p-type silicon substrate than the titanium nitride layer. This is reported in, for example, "Thin Solid Films", 96 (1982), pp 327-345.

To improve the productivity, there is adopted a method using a sputtering apparatus having a target in its vacuum chamber, in which semiconductor substrates are continuously supplied into the vacuum chamber and then subjected to sputtering, thereby to form contact portions. In such a method, it is effective to interpose a titanium layer between the titanium nitride layer and the silicon substrate in view of reduction in the generation of particle dust detrimental to a large-scale integrated circuit. More specifically, particles of titanium nitride attached to the wall of the vacuum chamber are liable to readily come off from the wall, while titanium particles hardly come off from the wall. When titanium particles are generated, in addition to particles of titanium nitride, in the vacuum chamber, the presence of the titanium particles causes the particles of titanium nitride to come off, with difficulty, from the wall of the vacuum chamber. Accordingly, the amount of layer removal from the wall of the vacuum chamber is lowered, thereby to lower the generation of particle dust.

In a deep submicron MOS-type very large-scale integrated circuit, the aspect ratio of each contact hole becomes great. It is therefore difficult to deposit a barrier layer in a sufficient thickness on the bottom of a contact hole by a usual sputter deposit method. The aspect ratio is about 2.0 in a CMOS of 0.35 ∼ 0.5µm, and not less than 4.0 in a DRAM of 0.35µm. Accordingly, the thickness of the barrier layer deposited on the bottom of a contact hole, is often equal to about 5 ∼ about 10% of the thickness of a layer deposited on a flat substrate.

To solve the problem above-mentioned, there is employed a method in which a collimator jig of a honeycomb structure is disposed between a substrate and the target of a sputter deposit apparatus and in which the vertical incident component of sputtered particles deposited on the substrate surface is increased in amount (a collimator sputter method).

However, it becomes difficult to dispose a shutter between the target and the substrate as done in prior art, since the collimator jig is disposed between the target and the substrate and it is required to maintain uniform the thickness of a layer formed on the substrate liable to be increased in diameter (not less than 6 inches). This is reported in, for example, "Journal of Vacuum Science and Technology", A9 (1991), pp 261-264.

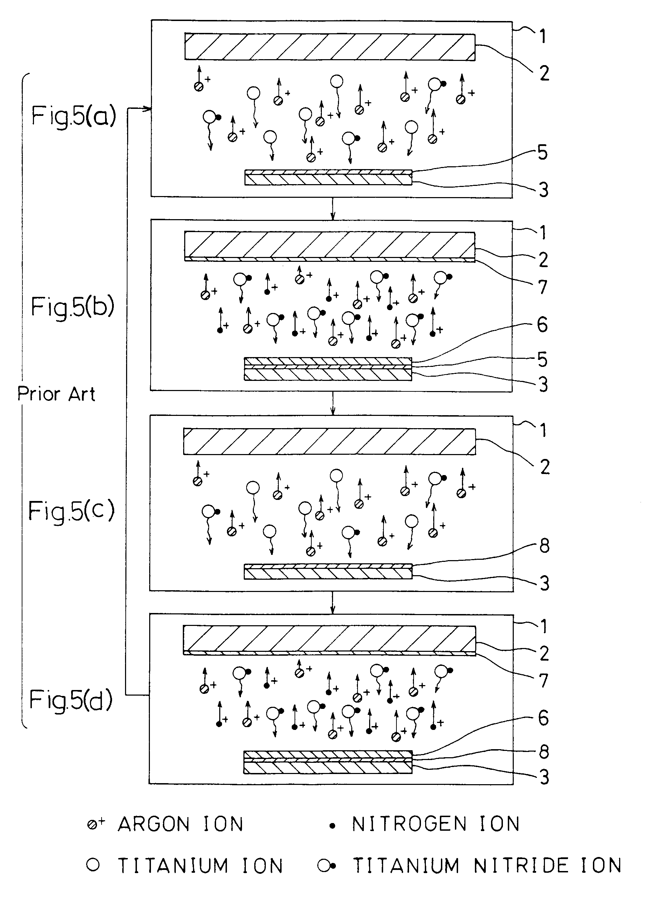

The inventors have found that, when silicon semiconductor substrates are continuously supplied into a vacuum chamber having no shutter and barrier layers of titanium nitride layers are formed on the semiconductor substrates through titanium layers, titanium-nitrogen mixture layers are disadvantageously formed, instead of titanium layers, on semiconductor substrates on and after the second semiconductor substrate. The following will discuss what would be considered as the reason. Fig. 5 (a) to Fig. 5 (d) show a method of producing a semiconductor device of the prior art. As shown in Fig. 5 (a), a titanium target 2 is disposed in a vacuum chamber 1 having no shutter, and the first silicon substrate 3 is delivered into the vacuum chamber 1. When argon gas is supplied into the vacuum chamber 1, argon ions generated from the argon gas come into collision with the target 2, titanium atoms are then emitted from the target 2, and a titanium layer 5 is then deposited on the silicon substrate 3.

Then, when argon gas mixingly containing nitrogen is fed into the vacuum chamber 1 and reactive sputtering is carried out, a titanium nitride layer 6 is deposited on the titanium layer 5 as shown in Fig. 5 (b). At this time, a titanium-nitrogen mixture layer 7 is stuck to the surface of the target 2.

Then, when each of silicon substrates 3 on and after the second silicon substrate is fed into the vacuum chamber 1 and argon gas is supplied, a titanium-nitrogen mixture layer 8 is deposited on each silicon substrate 3 as shown in Fig. 5 (c).

Then, when argon gas mixingly containing nitrogen is supplied into the vacuum chamber 1 and reactive sputtering is carried out, a titanium nitride layer 6 is deposited on each titanium-nitrogen mixture layer 8 as shown in Fig. 5 (d). At this time, each titanium-nitrogen mixture layer 7 is again stuck to the surface of the target 2. Thus, instead of the titanium layer 5, the titanium-nitrogen mixture layer 8 is disadvantageously interposed between the titanium nitride layer 6 and each of the silicon substrates 3 on and after the second silicon substrate.

As thus discussed, even though it is intended to deposit the titanium nitride layer 6 on each silicon substrate 3 through the titanium layer 5 by the method of prior art, the titanium-nitrogen mixture layer 8 is actually deposited on each of the silicon substrates 3 on and after the second silicon substrate. Thus, the contact resistance to the high-concentration diffusion layer formed on each of the silicon substrates 3 on and after the second silicon substrate, is disadvantageously higher than the value of resistance expected from the height of the Schottky barrier between each silicon substrate 3 and the titanium layer 5 and from the concentration of impurities in each high-concentration diffusion layer. It is therefore difficult to form an ohmic contact portion low in resistance in a semiconductor device obtained by the method of prior art. This is particularly remarkable when forming a p-type high-concentration diffusion layer on a silicon substrate.

### [Summary of the Invention]

In view of the foregoing, it is an object of the present invention to form, on each of semiconductor substrates, an ohmic contact portion low in resistance for electrically connecting each of the semiconductor substrates to a metallic wiring layer formed thereon, the semiconductor substrates being continuously supplied into a vacuum chamber having no shutter.

To achieve the object above-mentioned, a method of producing a semiconductor device according to the present invention comprises the steps of: continuously supplying semiconductor substrates of silicon into the chamber of a sputtering apparatus, a target of metal being disposed in the chamber; and forming, on each semiconductor substrate, a contact portion for electrically connecting the semiconductor substrate to a metallic wiring layer formed thereon, this contact portion forming step comprising: the substep of supplying, into the chamber, sputtering gas composed of a first substance for depositing, on each semiconductor substrate, a first metallic layer which is formed by the metal forming the target and which is low in resistance with respect to the semiconductor substrate; the substep of supplying, into the chamber, sputtering gas composed of the first substance and of a second substance different therefrom for depositing, on the first metallic layer, a second metallic layer formed by a compound of the metal forming the target and the second substance for preventing the semiconductor substrate from reacting with the metallic wiring layer; and the substep of supplying, into the chamber, sputtering gas composed of the first substance for removing the second substance stuck to the surface of the target and for depositing, on the second metallic layer, a third metallic layer formed by a mixture of the metal forming the target and the second substance.

When depositing the first metallic layer on each of the semiconductor substrates on and after the second semiconductor substrate, the second substance stuck to the surface of the target has already been removed. Accordingly, there is deposited, on each of the semiconductor substrates even on and after the second semiconductor substrate, the first metallic layer into which no other substance has been mixingly entered and which is low in resistance with respect to the semiconductor substrate. Thus, there can securely be produced a semiconductor device in which an ohmic contact portion low in resistance is formed on the semiconductor substrate thereof.

When the metal forming the target is high-melting-point metal, there can securely be formed an ohmic contact portion low in resistance particularly required when high-melting-point metal is deposited on a semiconductor substrate of silicon.

When the high-melting-point metal is titanium and the second substance is nitrogen, the contact portion can securely be provided with ohmic properties and low resistance properties which are particularly importrant when a titanium nitride layer is deposited on a semiconductor substrate of silicon through a titanium layer.

When the metallic wiring layer is formed by metal containing silicon, the thickness of the third metallic layer is preferably in the range of 8 to 12 nm. Since the thickness of the third metallic layer is not less than 8 nm, nitrogen stuck to the surface of the target is securely removed. Further, since the thickness of the third metallic layer is not greater than 12 nm, silicon contained in the metallic wiring layer is substantially not decreased in amount even though such silicon reacts with titanium forming the third metallic layer. This prevents silicon of the semiconductor substrate from diffusing into the metallic wiring layer or from being alloyed with the metal forming the metallic wiring layer to increase the junction leak electric current.

### [Description of the Drawings]

Fig. 1 is a section view illustrating the respective steps of a method of producing a semiconductor device according to an embodiment of the present invention;
Fig. 2 is a section view of a contact portion of a very large-scale integrated circuit produced by the method of producing a semiconductor device according to the embodiment of the present invention;
Fig. 3 is a characteristic view illustrating the relationship between contact hole diameter and contact resistance in each of contact portions formed by the method of producing a semiconductor device according to the embodiment of the present invention;
Fig. 4 (a) and Fig. 4 (b) illustrate the relationships between junction leak electric current and occurrence frequency at contact portions in semiconductor devices respectively formed by a method of prior art and the method of the present invention; and
Fig. 5 is a section view illustrating the respective steps of the method of prior art of producing a semiconductor device.

### [Detailed Description of the Invention]

With reference to attached drawings, the following description will discuss a method of producing a semiconductor device according to an embodiment of the present invention.

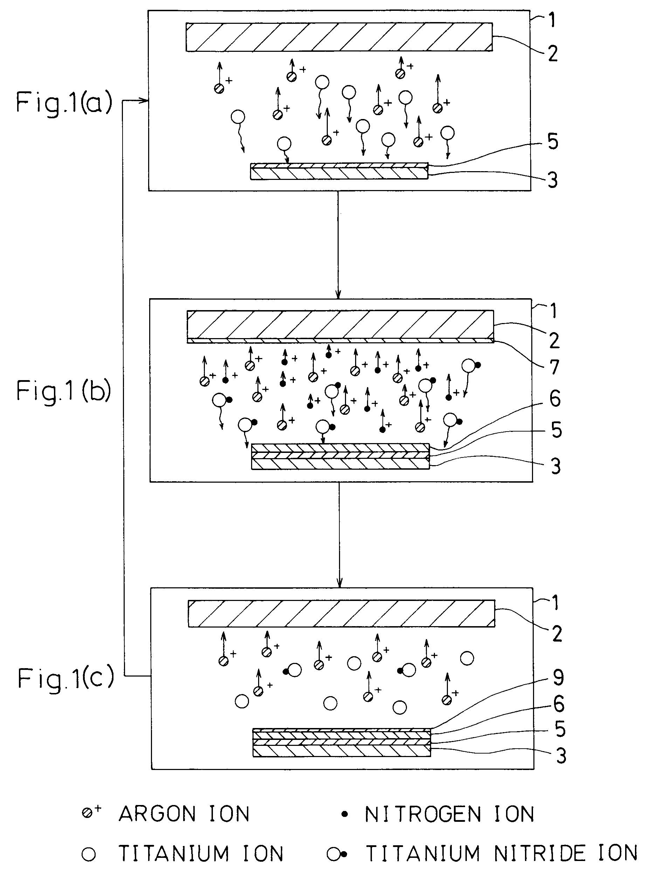

Fig. 1 (a) to Fig. 1 (c) illustrate the steps of continuously delivering silicon substrates 3 into a vacuum chamber 1 in which no shutter is disposed and in which a titanium target 2 is disposed, and forming a contact portion for electrically connecting each of the silicon substrates 3 to a metallic wiring layer formed thereon.

First, when argon gas is supplied into the vacuum chamber 1, argon ions generated from the argon gas come into collision with the target 2, titanium atoms are then emitted from the target 2 and a titanium layer 5 is then deposited on the first silicon substrate 3 as shown in Fig. 1 (a).

Then, when argon gas mixingly containing nitrogen is fed into the vacuum chamber 1 and reactive sputtering is carried out, a titanium nitride layer 6 is deposited on the titanium layer 5 as shown in Fig. 1 (b). At this time, a titanium-nitrogen mixture layer 7 is stuck to the surface of the target 2.

Then, when argon gas is again supplied into the vacuum chamber 1, the titanium-nitrogen mixture layer 7 stuck to the surface of the target 2 comes off therefrom, and there is deposited, on the titanium nitride layer 6, a titanium-nitrogen mixture layer 9 of which thickness is very thin, as shown in Fig. 1 (c). The thickness of the titanium-nitrogen mixture layer 9 is suitably in the range from 8 to 12 nm. More specifically, if the thickness of the titanium-nitrogen mixture layer 9 is thinner than 8 nm, the titanium-nitrogen mixture layer 7 stuck to the surface of the target 2 cannot sufficiently be removed. On the other hand, if the thickness of the titanium-nitrogen mixture layer 9 is thicker than 12 nm, a leak electric current is increased when a silicon-containing metallic wiring layer is formed on the contact portion. For example, when a metallic wiring layer made of an aluminium alloy (Al:1.0%, Si: 0.5%, Cu) is formed on the titanium-nitrogen mixture layer 9, aluminium and silicon forming the metallic wiring layer react with titanium forming the titanium-nitrogen mixture layer 9, thereby to form a compound of the Ti-Si-Al type. This reduces the amount of silicon in the metallic wiring layer. This causes silicon in the silicon substrate 3 to diffuse toward the metallic wiring layer or to be alloyed with aluminium in the metallic wiring layer. This provokes an increase in a junction leak electric current. However, when the thickness of the titanium-nitrogen mixture layer 9 is not greater than 12 nm, silicon in the metallic wiring layer is substantially not reduced in amount such that the junction leak electric current is not increased.

With the steps above-mentioned, there is finished the formation of a contact portion for electrically connecting the first silicon substrate 3 and the metallic wiring layer formed thereon. When each of the silicon substrates 3 on and after the second silicon substrate is then delivered into the vacuum chamber 1 and argon gas is supplied thereinto, the titanium-nitrogen mixture layer 7 stuck to the surface of the target 2 has already been removed. Accordingly, the target 2 emits titanium atoms and a titanium layer 5 containing no nitrogen is deposited on each silicon substrate 3 as shown in Fig. 1 (a).

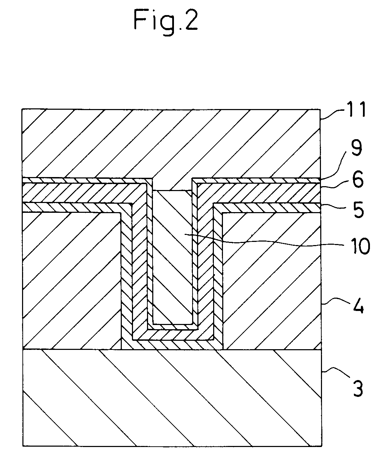

Fig. 2 shows a sectional structure of a contact portion in a very large-scale integrated circuit of the deep submicron level formed by the method above-mentioned. Referring to Fig. 2, the following description will discuss how to form a contact portion in such a very large-scale integrated circuit.

It is now supposed that there is formed, on the surface of a silicon substrate 3 with a surface azimuth (100), an n-type high-concentration diffusion layer by ion-injecting arsenic (As) into the silicon substrate 3, or a p-type high-concentration diffusion layer by ion-injecting boron fluoride (BF₂) into the n-type well zone of the silicon substrate 3.

An interlaminar insulator layer 4 made of a silicon oxide layer is deposited on the silicon substrate 3 by a CVD method, and the silicon substrate 3 is then thermally treated at 850 ∼ 900°C to activate the injected impurity ions.

By a dry etching method, a contact hole is formed in the interlaminar insulator layer 4 such that the contact hole reaches the surface of the silicon substrate 3. Thereafter, a cleaning operation is carried out by a wet process and the silicon natural oxide layer is removed.

By the method mentioned earlier, there are successively deposited, on the interlaminar insulator layer 4 and the silicon substrate 3 exposed to the contact hole, a titanium layer 5, a titanium nitride layer 6 and a titanium-nitrogen mixture layer 9. In this case, the titanium layer 5 of high purity is deposited on the silicon substrate 3. By a blanket tungsten CVD method, a tungsten layer is deposited on the entire surface of the titanium-nitrogen mixture layer 9. An etch back treatment is then conducted on the tungsten layer to form, in the contact hole, a plug 10 made of the tungsten layer. By a sputter deposit method, a metallic wiring layer 11 made of an aluminium alloy is then formed on the titanium-nitrogen mixture layer 9 and the plug 10.

By a usual photolithography technique, a resist pattern is formed on the metallic wiring layer 11. With the resist pattern serving as a mask, dry etching is carried out on the laminated layers of the metallic wiring layer 11, the titanium-nitrogen mixture layer 9, the titanium nitride layer 6 and the titanium layer 5, thus forming a laminated metallic wiring layer. Thereafter, the silicon substrate 3 is thermally treated at a temperature of 450°C in a hydrogen-nitrogen mixture forming gas, thereby to form an ohmic contact portion low in resistance.

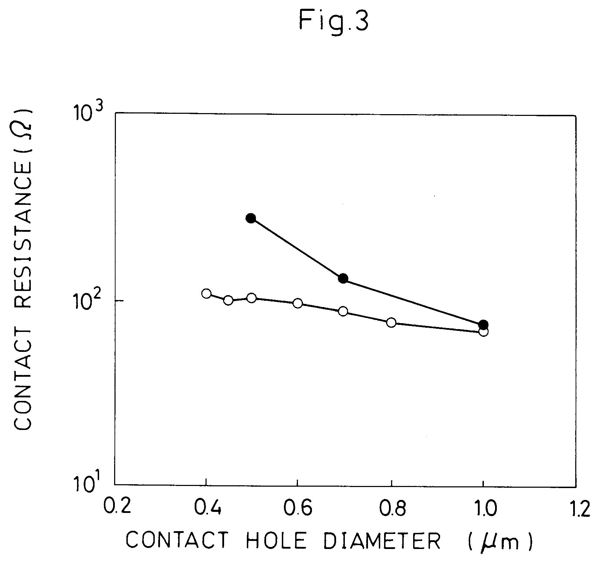

Fig. 3 shows the relationship between contact hole diameter and contact resistance as characteristics of each fine ohmic contact portion having a high aspect ratio. In Fig. 3, there are shown such relationships in contact portions which were formed for the p-type high-concentration diffusion layers by a method of prior art and by the method of the present invention. As apparent from Fig. 3, the property of low resistance is always assured in the contact portions formed according to the method of the present invention, even in the fine contact hole having a diameter of 0.4 µm.

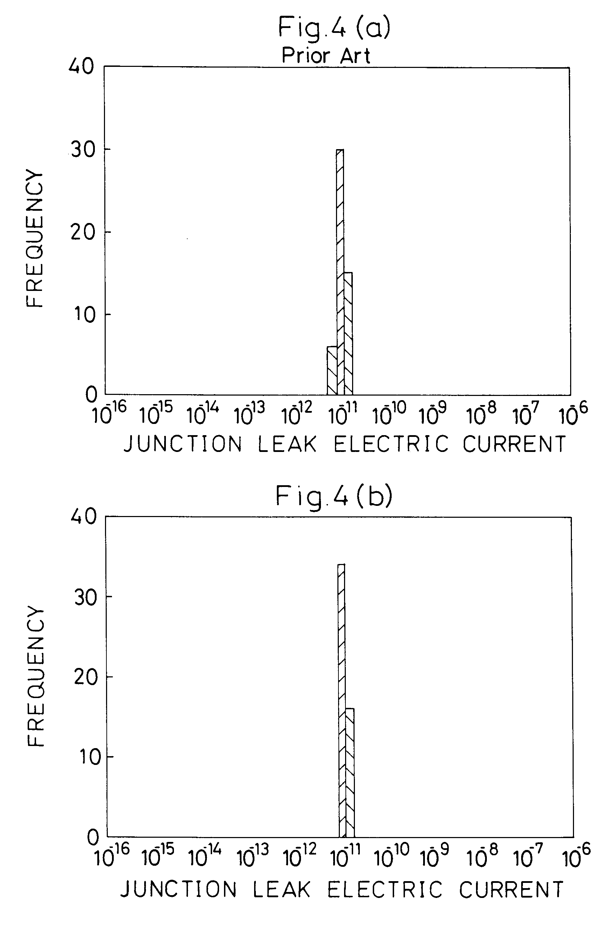

Fig. 4 (a) and Fig. 4 (b) show histograms illustrating the distributions of junction leak electric current at the p-n junctions as characteristics of ohmic contact portions. Fig. 4 (a) shows such a histogram of the contact portion formed by a method of prior art, while Fig. 4 (b) shows such a histogram of the contact portion formed by the method of the present invention. In each of Fig. 4 (a) and Fig. 4 (b), there is shown a junction leak electric current at the p-n junction between the p-type well zone and the n⁺-type high-concentration diffusion layer formed therein. As measuring conditions, a reverse bias voltage of 5.0 V was applied, the junction area was 320,000 µm², the contact area was 4,357 µm² and the thickness of the titanium-nitrogen mixture layer 9 was 10 nm. As apparent from Fig. 4 (a) and Fig. 4 (b), the contact portion formed by the method of prior art and the contact portion formed by the method of the present invention, show substantially the same distribution of junction leak electric current.

As mentioned earlier, when the metallic wiring layer 11 made of an aluminium alloy is formed on the titanium-nitrogen mixture layer 9, silicon and aluminium forming the metallic wiring layer 11 react with titanium forming the titanium-nitrogen mixture layer 9, so that the junction leak electric current is possibly increased. In the embodiment, however, it may be considered that the junction leak electric current is not increased so that silicon in the metallic wiring layer 11 is not substantially be lowered in amount although the titanium-nitrogen mixture layer 9 is formed on the titanium nitride layer 6.

As discussed in the foregoing, according to the embodiment, when continuously depositing the titanium layer 5 and the titanium nitride layer 6 on the silicon substrate 3 using a sputter deposit apparatus having no shutter in the vacuum chamber 1 (for example, a collimator sputter deposit apparatus), the titanium-nitrogen mixture layer 9 having a thickness of about 10 nm is deposited on the titanium nitride layer 6. Accordingly, the contact portion is of a three-layer structure having the titanium layer 5, the titanium nitride layer 6 and the titanium-nitrogen mixture layer 9. This prevents nitrogen from mixingly entering the lowermost layer or titanium layer 5. It is therefore possible to form, on the silicon substrate 3, an ohmic contact portion low in resistance.

In the embodiment, the contact portion is of a three-layer structure having the titanium layer 5, the titanium nitride layer 6 and the titanium-nitrogen mixture layer 9. Alternately, there may be employed any of combinations marked with ○ in Table 1. For example, when boron (B) and titanium (Ti) are combined, there is formed a three-layer structure of a titanium layer, a layer of titanium boride and a titanium-boron mixture layer.

**[Table 1]**

| | Ti | Zr | Nb | Mo | Hf | Ta | W | Ru |
|---|---|---|---|---|---|---|---|---|
| B | ○ | | | | | | | |
| C | ○ | | ○ | | | ○ | | |
| N | ○ | ○ | ○ | ○ | ○ | ○ | ○ | |
| O | | | | | | | | ○ |

## Claims

1. A method of producing a semiconductor device comprising the steps of: continuously supplying semiconductor substrates of silicon into the chamber of a sputtering apparatus, a target of metal being disposed in said chamber; and forming, on each semiconductor substrate, a contact portion for electrically connecting said semiconductor substrate to a metallic wiring layer formed thereon,
said contact-portion forming step comprising:
the substep of supplying, into said chamber, sputtering gas composed of a first substance for depositing, on each semiconductor substrate, a first metallic layer which is formed by said metal forming said target and which is low in resistance with respect to said semiconductor substrate;
the substep of supplying, into said chamber, sputtering gas composed of said first substance and of a second substance different therefrom for depositing, on said first metallic layer, a second metallic layer formed by a compound of said metal forming said target and said second substance for preventing said semiconductor substrate from reacting with said metallic wiring layer; and
the substep of supplying, into said chamber, sputtering gas composed of said first substance for removing said second substance stuck to the surface of said target and also for depositing, on said second metallic layer, a third metallic layer formed by a mixture of said metal forming said target and said second substance.

2. A method of producing a semiconductor device according to Claim 1, wherein the metal forming the target is high-melting-point metal.

3. A method of producing a semiconductor device according to Claim 2, wherein the high-melting-point metal is titanium, and the second substance is nitrogen.

4. A method of producing a semiconductor device according to Claim 3, wherein the metallic wiring layer is formed by metal containing silicon, and the thickness of the third metallic layer is in the range of 8 to 12 nm.
